Europäisches Patentamt

European Patent Office

Office européen des brevets

(19)

(11) Numéro de publication: **0 108 671**
**B1**

(12) **FASCICULE DE BREVET EUROPEEN**

(45) Date de publication du fascicule du brevet: **18.01.89**

(51) Int. Cl.⁴: **G 01 R 15/07**, G 01 K 11/12

(21) Numéro de dépôt: **83402047.1**

(22) Date de dépôt: **21.10.83**

(54) **Dispositif de mesure de température et/ou d'intensité électrique à effet Faraday.**

(30) Priorité: **28.10.82 FR 8218102**

(43) Date de publication de la demande:
**16.05.84 Bulletin 84/20**

(45) Mention de la délivrance du brevet:
**18.01.89 Bulletin 89/03**

(84) Etats contractants désignés:
**DE GB NL**

(56) Documents cités:
**DE-A-2 855 337**
**DE-A-2 924 804**
**FR-A-2 492 986**
**US-A-3 605 013**
**US-A-4 298 245**

**MESURES - REGULATION- AUTOMATISME,
vol. 47, no. 3, mars 1982, pages 65-69, Paris,
FR:"Un capteur de courant a fibres optique
pour l'an 2000?"**

(73) Titulaire: **COMMISSARIAT A L'ENERGIE
ATOMIQUE
31/33, rue de la Fédération
F-75015 Paris (FR)**

(72) Inventeur: **Langeac, Daniel
4, Place Jean Moulin
F-38000 Grenoble (FR)**

(74) Mandataire: **Mongrédien, André et al
c/o BREVATOME 25, rue de Ponthieu
F-75008 Paris (FR)**

Courier Press, Leamington Spa, England.

EP 0 108 671 B1

## Description

La présente invention se rapporte à la mesure des températures et/ou des courants électriques par effet Faraday et trouve une application plus particulièrement dans le cas où cette mesure a lieu dans un environnement difficile, notamment sur des conducteurs électriques portés à une tension élevée par rapport au sol ou dans des ambiances soumises à des variations de température importantes.

Le dispositif, objet de l'invention, met en oeuvre les techniques connues de mesure magnéto-optiques de courant.

L'effet magnéto-optique utilisé est l'effet Faraday selon lequel le plan de polarisation d'un faisceau lumineux, polarisé linéairement, tourne d'un angle ω sous l'effet d'un champ magnétique H créé par le courant à mesurer et proportionnel à l'intensité I de ce dernier. L'angle ω de rotation du plan de polarisation de la lumière soumis au champ magnétique H est, en première approximation, proportionnel à ce champ et donc à l'intensité I qui lui a donné naissance. On conçoit par conséquent facilement la possibilité de réaliser, en utilisant cet effet Faraday connu, un dispositif de mesure d'intensité électrique.

En effet, de façon plus précise, l'angle ω de rotation du plan de polarisation de la lumière est donné par la formule:

$$\omega = V_e \int \overline{H} . \overline{dl}$$

formule dans laquelle: $\overline{H}$ est le champ mangétique créé par le courant I à mesurer et auquel on soumet précisément un échantillon de lumière polarisée; I est la longueur d'interaction entre le champ et le parcours du rayon lumineux polarisé; $V_e$ est une constante spécifique du mileu, appelée constante de Verdet. Cette constante est importante pour les corps ferromagnétiques et faible pour les corps diamagnétiques, tels que les fibres optiques. Il est important par ailleurs de noter que, pour les milieux diamagnétiques, elle est indépendante de la température.

D'après le théorème d'Ampère, on peut écrire:

$$\int \overline{H} . \overline{dl} = NI$$

sur une courbe fermée, N étant le nombre de tours de la lumière autour du conducteur parcouru par l'intensité I.

Ce qui revient à écrire $\omega = V_e NI$, formule qui établit la proportionnalité du courant I et de l'angle ω.

Des dispositifs ampèremétriques de mesure d'intensité électrique bâtis sur l'effet Faraday sont décrits notamment dans les articles suivants:

(1) "Mesure d'un courant par un ampèremètre à effet Faraday" oar P.HEROIN, Ch. BENOIST et Y. DE LA MARRE, publié dans le Revue Générale de l'Electricité, juillet-août 1967, p. 1045;

(2) "Optical Fibers for Current Measurement Applications" par A. M. SMITH, publié dans la Revue Optics and Laser Technology, février 1980, p. 25.

Dans cette technique, il a été proposé, pour mesurer le courant dans un conducteur, d'enrouler une fibre optique monomode autour du conducteur, de manière à augmenter la longueur d'interaction entre le champ magnétique et l'onde lumineuse se propageant dans la fibrer optique. De ce fait, on peut compenser la valeur faible de la constante de Verdet dans un milieu diamagnétique par une grande longueur d'interaction magnéto-optique et bénéficier de l'invariance de cette constante avec la température dans un tel milieu.

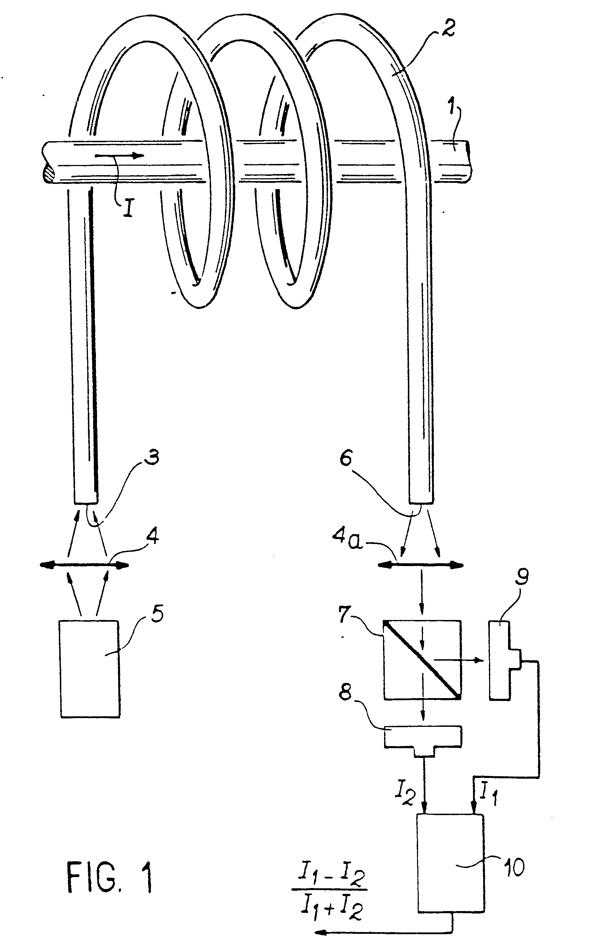

Un dispositif de mesure d'intensité électrique par effet Faraday d'un type en soi connu est représenté sur la figure 1 ci-jointe. Il comporte, enroulée à la manière d'un solénoïde autour d'un conducteur 1 parcouru par un courant électrique I que l'on veut mesurer, une fibre optique 2 du type monomode et comportant une ou plusieurs spires autour du conducteur 1. L'extrémité d'entrée 3 de la fibre optique 2 est couplée par une lentille 4 à une source lumineuse polarisée linéairement qui peut être avantageusement par example une diode laser 5. L'extrémité de sortie 6 de la fibre optique 2 est suivie d'une lentille 4a et d'un dispositif d'analyse de la rotation du plan de polarisation de la lumière ayant parcouru la fibre optique 2 depuis son entrée en 3 dans celle-ci.

Ce dispositif peut être par exemple un prisme de Wollaston donnant deux faisceaux lumineux, d'intensités respectives $I_1$ et $I_2$, polarisés linéairement et orthogonalement, reçus par des moyens de détection de lumière connectés à un curcuit électronique analogique calculant l'expression $P = (I_1 - I_2)/(I_1 + I_2)$. Il est connu que cette expression P est égale à sin2ω, valeur voisine de 2ω lorsque ω est faible, ce qui est généralement le cas pour les champs magnétiques engendrés par les courants que l'on veut mesurer (par example, les courants circulant dans les réseaux de distribution électrique). Le circuit électronique fournit donc un signal proportionnel à l'intensité I à mesurer.

Le dispositif d'analyse de la polarisation lumineuse à la sortie 6 de la fibre 2 peut être aussi bien d'ailleurs un cube séparateur associé à deux polariseurs croisés ou, comme c'est le cas sur la figure 1, un cube séparateur polariseur 7 associé à deux photodiodes 8 et 9 détectant chacune des intensités $I_1$ et $I_2$ des deux faisceaux lumineux polarisés linéairement et orthogonalement. Une unité électronique anologique 10 calcule ensuite le rapport

$$P = \frac{I_1 - I_2}{I_1 + I_2}$$

dont il a été question précédemment et qui est représentatif de l'intensité I à mesurer dans le conducteur 1.

Malheuresement, le dispositif connu de la figure 1 ne permet pas d'obtenir des mesures d'intensité précises et cohérents si l'on ne prend pas la précaution de s'affranchir des phénomènes de biréfringence linéaire parasite qui sont causés par de nombreux phénomènes (procédé de fabrication, courbure de la fibre, variations de température) dans une fibre optique classique monomode. Ces phénomènes parasites de biréfringence linéaire ont notamment l'inconvénient grave de détruire la linéarité de la polarisation de l'onde lumineuse au cours de son trajet dans la fibre optique.

Pour lutter contre cette difficulté, on a déjà proposé une solution qui consiste à torsader la fibre optique autour de son axe longitudinal pour annuler macroscopiquement les phénomènes de biréfringence précédents, c'est le cas, notamment, du brevet belge BE—A—880 755.

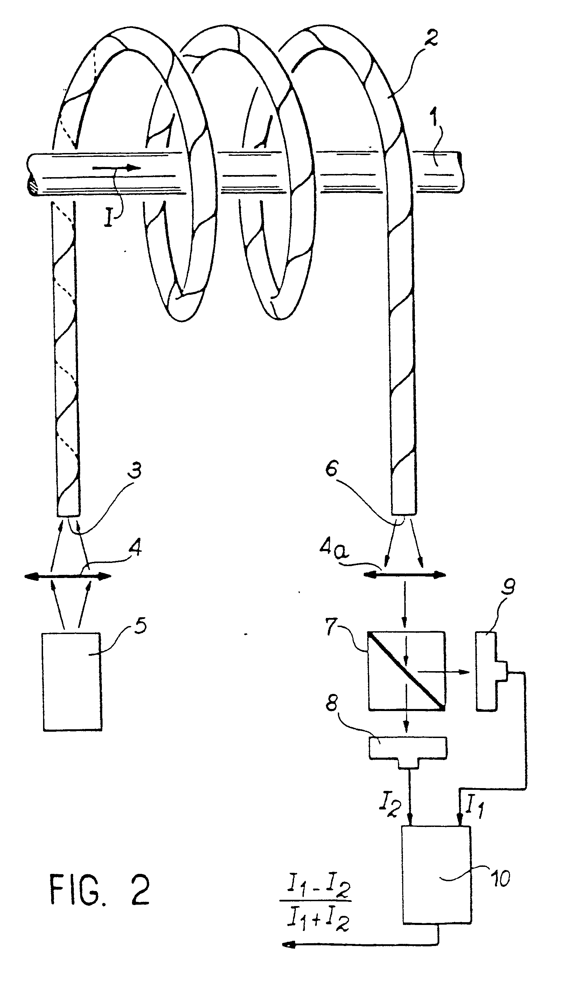

Un tel dispositif, également connu, est représenté sur la figure 2 où l'on retrouve tous les éléments de la figure 1 à ceci près que, comme l'indique schématiquement le profil d'une génératrice de la surface de la fibre optique alternativement en trait plein et en trait pointillé, cette dernière a été torsadée longitudinalement avant d'être enroulée sous forme de solénoïde autour de conducteur 1 dans lequel passe l'intensité I à mesurer.

En fait, si le dispositif de la figure 2 permet de conserver son caractérisé linéaire à la polarisation de l'onde lumineuse traversant la fibre 2, la torsion de cette dibre optique provoque en revanche une activitié optique systématique, en l'occurrence une rotation naturelle du plan de polarisation de la lumière, qui varie en fonction de la température. Il en résulte par conséquent que si l'on utilise un dispositif comportant la compensation de la figure 2 dans un mileu où la température évolue, sans prendre de précaution spéciale pour éliminer l'influence de cette température, il est impossible de distinguer dans la rotation résultant de ce plan de polarisation la composante qui est due aux variations de température et la composante due à l'effet Faraday proprement dit.

Le brevet belge BE—A—883 812 divulgue un dispositif de mesure d'intensité électrique à effet Faraday à l'aide de moyens magnéto-optiques comprenant une sonde constituée d'une fibre optique torsadée autour de son axe longitudinal et enroulée sous la forme d'un solénoide (voir la figure): il constante l'influence des variations de la température sur l'angle de rotation du plan de polarisation de la lumière (voir p. 2, l. 16 à 22) et propose une méthode pour supprimer ladite influence de la température. Cette méthode consiste, principalement, à renvoyer, par réflexion à la sortie de la fibre, la lumière polarisée pour lui faire subir le même trajet en sens inverse.

La présente invention a précisément pour objet un dispositif de mesure de température et d'intensité électrique à effet Faraday qui met en oeuvre des moyens simples permettant, dans des dispositifs dérivés de celui de la figure 2 précédente, de séparer la composante de rotation du plan de polarisation due à l'effet Faraday proprement dit de celle qui résulte des variations de température.

Ce dispositif de mesure à l'aide de moyens magnéto-optiques comprenant de façon connue une sonde constituée d'une fibre optique enroulée sous la forme générale d'un solénoïde entourant un conducteur électrique parcouru par l'intensité à mesurer et deux brins de fibre optique reliant ladite sonde à une entrée couplée à une source de lumière polarisée et à une sortie couplée à des premiers moyens de mesure comportant un calculateur qui fournit une grandeur électrique $S_1$ représentant l'angle de rotation du plan de polarisation de la lumière entre son entrée et sa sortie dans le dispositif, la portion de fibre optique constituant la sonde étant torsadée autour de son axe longitudinal dans un sans unique indifférent, la face de sortie de la fibre étant équipée d'une lame semi-transparante apte à renvoyer, selon le trajet inverse, une partie au moins du faisceau lumineux vers l'entrée du dispositif, se caractérisé en ce que les deux brins de fibre optique reliant ladite sonde respectivement à l'entrée et à la sortie du dispositif sont torsàdés en sens inverse, le nombre le tours de torsion dextrogyre de l'un des brins étant égal au nombre de tours de torsion sinistrogyre de l'autre, et en ce que le dispositif comporte:

à l'entrée du dispositif une lame semi-transparente, à 45° sur le faisceau de lumière incident, apte à diriger une partie du faisceau lumineux de retour inverse vers des seconds moyens de mesure comportant un calculateur qui fournit une grandeur électrique $S_2$ représentant l'angle de rotation du plan de polarisation de la lumière depuis son entrée dans le dispositif et donnant la valeur de l'intensité I à mesurer;

un calculateur formant l'expression 2 $S_1$—$S_2$ des grandeurs électriques présentes aux sorties respectives des calculateurs et cette expression 2 $S_1$—$S_2$ étant caractéristique de la température à mesurer.

Le dispositif de mesure perfectionné qui vient d'être décrit, comporte donc la détection de la rotation du plan- de polarisation de la lumière ayant traversé le système selon deux modalités différentes. Des premiers moyens de mesure situés à la sortie du système déterminent la rotation de ce plan de rotation sur la partie de la lumière qui a traversé une fois le système; en revanche, des seconds moyens de mesure de cet angle de rotation du plan de polarisation mesurement à l'entrée du système la rotation de la partie du faisceau lumineux qui a effectué, après réflexion sur une lame semi-transparente située à la sortie de la fibre, un trajet aller-retour dans celle-ci. Il en résulte que l'on détecte à la sortie du système une rotation du plan de polarisation de la lumière dont la grandeur s'exprime par la formule:

$$S_1 = V_e NI + \alpha(T)$$

formule dans laquelle $V_e$ est la constante de Verdet, N le nombre de tours du solénoïde constituant la sonde, I l'intensité à mesurer et α(T) une fonction de la température du lieu où se trouve la sonde, c'est-à-dire du voisinage immédiat du conducteur parcouru par l'intensité à mesurer. En effet, les deux brins de couplage de la fibre optique avec la sonde à l'entrée et à la sortie, étant torsadés en sens inverse et avec une torsion résultante nulle, les variations de température éventuellement rencontrées par ces deux brins sont parfaitement compensés et, seule, la portion de fibre optique correspondant au solénoïde constituant la sonde est réceptive aux variations de température, c'est-à-dire à la fonction α(T).

A l'entrée du système, on recueille un signal $S_2=2V_eNI$, correspondant au double du signal de Faraday pour un trajet simple, mais cette fois sans composante correspondant à la température puisque les deux trajets étant effectués chacun dans un sens différent, les deux composantes dues à la température à l'emplacement de la sonde s'annulent.

On voit ainsi que le dispositif de mesure perfectionné décrit permet d'obtenir la valeur du courant par le signal receuilli sur la sonde d'entrée $S_2$ et qu'il suffit de former, dans un calculateur, l'expression $2S_1—S_2=2α(T)$ pour obtenir la température. On a donc bien réalisé ainsi un appareil capable de mesurer simultanément au même endroit, l'intensité parcourant un conducteur et la température dans l'environnement immédiat de ce même conducteur.

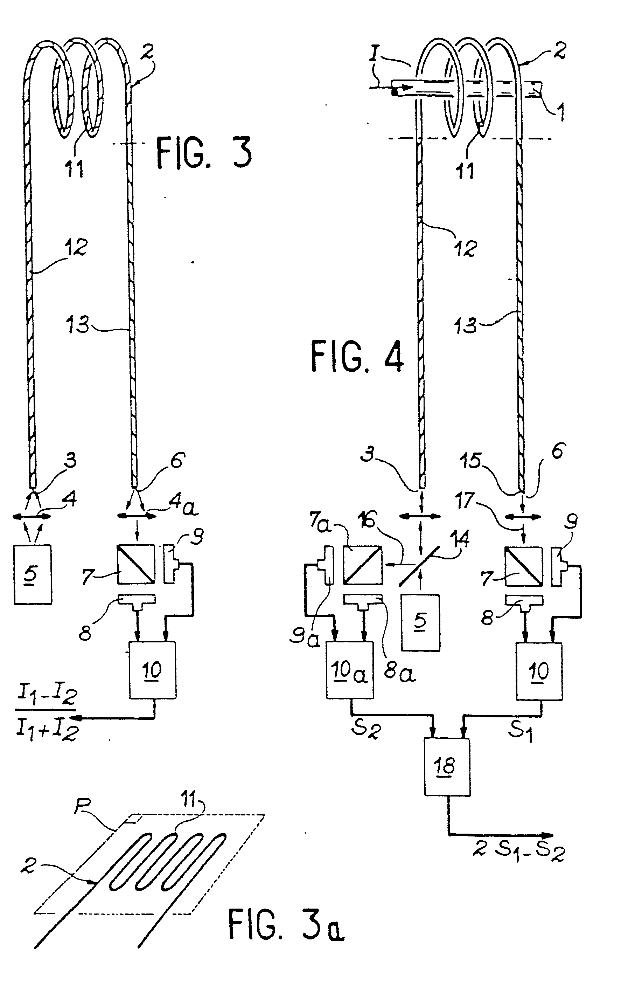

De toute façon, l'invention sera mieux comprise en se référant à la lecture qui suit de la description de plusieurs exemples de réalisation du dispositif de mesure, description qui sera faite à tire surtout illustratif et non limitatif en se référant aux figures 3 et 4 ci-jointes sur lesquelles:

la figure 3 montre un dispositif de mesure fonctionnant comme une sonde de mesure de la température,

la figure 3a montre une variante de la sonde de la figure 3,

la figure 4 représente un dispositif de mesure selon l'invention permettant à la fois la mesure d'une intensité électrique et de la température au voisinage immédiat du conducteur parcouru par cette intensité.

Sur la figure 3, on a représenté un système comportant, comme sur la figure 2, une fibre optique 2 ayant une entrée 3 et une sortie 6, une sonde 11 sous forme d'un solénoïde comprenant un certain nombre de tours ou d'un dispositif comportant dans un plan P une fibre optique en épingle à cheveux ou en peigne comme visible sur la figure 3a. Cette sonde 11 est reliée par deux brins de fibre optique 12 et 13 respectivement à l'entrée 3 et à la sortie 6 du système. Pour tout ce qui concerne l'alimentation en lumière polarisée linéairement et la mesure de la rotation du plan de polarisation de la lumière à la sortie 6, les moyens utilisés sont classiques et peuvent être notamment identiques à ceux de la figure 2, cas représenté pratiquement sur la figure 3 où on les retrouve portant les mêmes nombres de référence.

Les deux brins de jonction de la fibre optique 12 et 13 sont torsadés en sens inverse, c'est-à-dire que le nombre de tours de torsion dextrogyre de l'un des brins, 12 par exemple, est égal au nombre de tours de torsion sinistrogyre de l'autre, 13. De cette façon, on parvient à une compensation exacte des effets induits par les variations de température dans l'espace entourant les brins de dibres optiques 12 et 13 et la rotation du plan de polarisation lue à la sortie du calculateur 10 est fonction uniquement de la température qui règne au voisinage de la sonde 11. Bien entendu la portion de fibre optique constituant la sonde 11 est également torsadée autour de son axe longitudinal, mais dans le même sens (qui peut être d'ailleurs dextrogyre ou sinistrogyre), tout le long de cette sonde 11.

A titre d'indication, les deux brins 12 et 13 peuvent être constitués par une fibre optique monomode vendue par la firme ITT sous la référence T—1602 dont la rupture dynamique correspond à une torsion de 400 tours par mètre. Dans l'exemple décrit, on a utilisé une torsion de 80 tours par mètre sur chacun des brins, ce qui conduit à une rotation ω du plan de polarisation de la lumière égal à 20° d'angle pour une variation de température de 20° à 120°C. On obtient donc ainsi un dispositif de mesure fiable et de précision très satisfaisante. La sonde en forme de solénoïde 11 a un diamètre de 5 cm et comporte 7 spires d'une fibre optique d'un diamètre de 0,5 mm. Elle est également torsadée le long de son axe à 80 tours par mètre. Dans l'exemple décrit, les deux brins 12 et 13 ayant la même longueur de 1 mètre, leur taux de torsion est évidemment le même. Si pour des applications particulières, les deux brins 12 et 13 n'avaient plus strictement la même longueur, il suffirait alors de respecter la condition de résultante nulle du nombre de tours de torsion dans un sens et dans l'autre pour chacun des brins.

On peut remarquer encore, parmi les avantages du dispositif objet de la figure 3, que la proximité d'un conducteur électrique, à condition bien entendu qu'il ne soit pas placé à l'intérieur de la boucle du solénoïde 11, est sans influence aucune sur la mesure de la température, ceci en raison du théorème d'Ampère.

Sur la figure 4, on retrouve une fois de plus les mêmes éléments que sur la figure 3, portant les mêmes références, à ceci près qu'un conducteur 1 parcouru par un courant I à mesurer est situé dans l'axe du solénoïde constituant la sonde 11. Par ailleurs, et conformément à l'invention, deux lames semi-transparentes 14 et 15 sont situées respectivement à l'entrée 3 et à la sortie 6 du système. La lame 14 est inclinée à 45° et permet de sortir le rayon lumineux 16 qui est utilisé dans les seconds moyens de mesure de l'angle de rotation du plan de polarisation de la lumière, lesquels peuvent être de tout genre en soi connu. Une deuxième lame semi-transparente 15 est située à l'extrémité 6 du brin de fibre optique 13 pour assurer le retour d'une patie du flux lumineux sur le trajet inverse vers l'entrée 3 de la fibre 12.

Sur la figure 4, on a représenté, à l'entrée 3, des

## EP 0 108 671 B1

seconds moyens de lecture de la rotation de l'angle de polarisation identiques à ceux des figures 2 et 3; à la sortie du calculateur 10a, on lit la grandeur $S_2$ définie précédemment. Des moyens identiques se situent d'ailleurs sur la sortie 6 du système où le calculateur 10 élabore la grandeur $S_1$.

Selon l'invention, les signaux $S_1$ et $S_2$ présents respectivement sur les trajets lumineux 17 et 16 sont envoyés à leur sortie des calculateurs 10a et 10 dans un calculateur analogique 18 qui forment l'expression $2 S_1 — S_2$, laquelle représente la température dans la sonde 11. La grandeur $S_2$ à elle seule, est représentative, pour les raisons indiquées précédemment, du courant I circulant dans le conducteur 1 à l'intérieur de la sonde 11.

Bien entendu, dans le dispositif de la figure 4, la portion de fibre optique constituant le solénoïde 11 de la sonde est torsadée autour de son axe longitudinal dans le même sens, indifféremment d'ailleurs dextrogyre ou sinistrogyre; les deux brins de raccordement 12 et 13 de cette sonde 11 avec les extrémités d'entrée 3 et de sortie 6 du système, sont eux, torsadés en sens inverse, c'est-à-dire qu'ils comprennent un nombre de tours de torsion résultante nul.

### Revendication

Dispositif de mesure de température et d'intensité électrique à effet Faraday à l'aide de moyens magnéto-optiques comprenant une sonde (11) constituée d'une fibre optique (2) enroulée sous la forme générale d'un solénoïde entourant un conducteur électrique (1) parcouru par l'intensité à mesurer et deux brins de fibre optique (12, 13) reliant ladite sonde (11) à une entrée (3) couplée à une source de lumière polarisée (5) et à une sortie (6) couplée à des premiers moyens de mesure (7, 8, 9, 10) comportant un calculateur qui fournit une grandeur électrique $S_1$ représentant l'angle de rotation du plan de polarisation de la lumière entre son entrée et sa sortie dans le dispositif, la portion de fibre optique (2) constituant la sonde (11) étant torsadée autour de son axe longitudinal dans un sans unique indifférent, la face de sortie (6) de la fibre (2) étant équipée d'une lame semi-transparante (15) apte à renvoyer, selon le trajet inverse, une partie au moins du faisceau lumineux vers l'entrée (3) du dispositif, se caractérisé en ce que les deux brins de fibre optique (12, 13) reliant ladite sonde (11) respectivement à l'entrée (3) et à la sortie (6) du dispositif sont torsadés en sens inverse, le nombre de tours de torsion dextrogyre de l'un des brins étant égal au nombre de tours de torsion sinistrogyre de l'autre, et en ce que le dispositif comporte:

à l'entrée (3) du dispositif une lame semi-transparente (14), à 45° sur le faisceau de lumière incident, apte à diriger une partie (16) du faisceau lumineux de retour inverse vers des seconds moyens de mesure (7a, 8a, 9a, 10a) comportant un calculateur qui fournit une grandeur électrique $S_2$ représentant l'angle de rotation du plan de polarisation de la lumière depuis son entrée dans le dispositif et donnant la valeur de l'intensité I à mesurer;

un calculateur (18) formant l'expression $2 S_1 — S_2$ des grandeurs électriques présentes aux sorties respectives des calculateurs (10) et (10a) cette expression $2 S_1 — S_2$ étant caractéristique de la température à mesurer.

### Patentanspruch

Vorrichtung zum Messen von Temperatur oder elektrischer Intensität unter Anwendung des Farraday-Effekts mit Hilfe von magneto-optischen Einrichtungen, umfassend eine aus einer im wesentlichen in Form einer Spule gewickelten Lichtleiterfaser (2), welche einen von der zu messenden Intensität durchflossenen elektrischen Leiter (1) umgibt, gebildete Sonde (11) und zwei Lichtleiterfaserstränge (12, 13) welche die Sonde (11) mit einem mit einer Quelle (5) für polarisiertes Licht gekoppelten Eingang (3) und einem Ausgang (6) verbinden, welcher mit einer ersten Meßeinrichtung (7, 8, 9, 10) gekoppelt ist, umfassend einen Rechner (10), welcher eine den Verdrehungswinkel der Polarisationsebene des Lichts zwischen seinem Eintritt in und seinem Austritt aus der Vorrichtung darstellende elektrische Göße (S1) liefert, wobei der die Sonde (11) bildende Abschnitt der Lichtleiterfaser (2) in einer einzigen, beliebigen Richtung um seine Längsachse gedreht ist und die Austrittsfläche (6) der Lichtleiterfaser (2) mit einer halb durchsichtigen Schicht (15) versehen ist, welche wenigstens ein Teil des Lichtbündels in umgekehrter Richtung zum Eingang (3) der Vorrichtung reflektiert, dadurch gekennzeichnet, daß die beiden die Sonde (11) mit dem Eingang (3) bzw. dem Ausgang (6) der Vorrichtung verbindenden Lichtleiterfaserstränge (12, 13) in entgegengesetzten Richtungen gedreht sind, wobei die Anzahl der Rechtsdrehungen des einen Strangs gleich der Anzahl der Linksdrehungen des anderen ist, und daß die Vorrichtung an ihrem Eingang (3) eine in einem Winkel von 45° zum einfallenden Lichtbündel geneigte, halb durchsichtige Scheibe (14) aufweist, welche einen Teil (16) des zurückgeleiteten Lichtbündels zu einer zweiten Meßeinrichtung (7a, 8a, 9a, 10a) reflektiert, umfassend einen Rechner (10a), welcher eine den Drehwinkel der Polarisationsebene des Lichts seit dessen Eintritt in die Vorrichtung widergebende elektrische Größe (S2) liefert und den Wert der zu messenden Intensität I angibt, sowie einen Rechner (18), welcher aus den an den jeweiligen Ausgängen der Rechner (10 und 10a) erscheinenden elektrischen Größen denn Ausdruck $2 S1 — S2$ bildet, wobei der Ausdruck $2 S1 — S2$ charakteristisch für die zu messende Temperatur ist.

### Claim

The measuring apparatus comprises in per se known manner magneto-optical means comprising a probe (11) constituted by an optical fibre (2) wound in the general shape of a solenoid

surrounding an electrical conductor (1) traversed by the intensity to be measured and two optical fibre strands (12, 13) connecting said probe (11) to an inlet (3) couled to a polarized light source (5) and to an outlet (6) coupled to first measuring means (7, 8, 9, 10), incorporating a computer (10) supplying an electrical quantity $S_1$ representing the rotation angle of the light polarization plane between its inlet and outlet with respect to the apparatus, the optical fibre portion (2) constituting the probe (11) being twisted around its longitudinal axis in a single random direction, the outlet (6) face of the fibre (2) being equipped with a semitransparent plate (15) able to reflect, in accordance with the reverse path, at least part of the light beam towards the inlet (3) of the apparatus, characterized in that the two optical fibre strands (12, 13) connecting said probe (11) respectively to the inlet (3) and the outlet (6) of said apparatus are twisted in the reverse direction, the number of twisting turns to the right of one of the strands being equal to the number of twisting turns to the left of the other and in that the apparatus has at the inlet (3) thereof a semitransparent plate (14) at 45° with respect to the incident light beam and able to direct part (16) of the reverse return light beam towards second measuring means (7a, 8a, 9a, 10a), having a computer (10a) supplying an electrical quantity $S_2$ representing the rotation angle of the polarization plane of the light from its entrance into the apparatus and giving the value of the intensity I to be measured and a computer (18) forming the expression $2S_1 - S_2$ of the electrical quantities present at the respective outputs of the computers (10 and 10a), said expression $2S_1 - S_2$ being characteristic of the temperature to be measured.

EP 0 108 671 B1

FIG. 1

FIG. 2

$$\frac{I_1 - I_2}{I_1 + I_2}$$

FIG. 3

11

2

12

13

3

4

5

6

4a

9

7

8

10

$$\frac{I_1 - I_2}{I_1 + I_2}$$

I

2

1

11

12

13

FIG. 4

3

15

6

7a

16

14

17

9

7

8

9a

8a

10a

5

10

$S_2$

$S_1$

18

$2 S_1 - S_2$

P

11

2

FIG. 3a